# EUROPEAN PATENT APPLICATION

(11) **EP 2 362 425 A1**
(43) Date of publication of application: **31.08.2011**
(21) Application number: 10290100.6
(22) Date of filing: 26.02.2010
(51) Int. Cl.: H01L 31/0224, H01L 31/18

(54) **A method for forming a selective contact**

(71) Applicant: Excico Group NV, 3500 Hasselt (BE)
(72) Inventor: Emeraud, Thierry, 3500 Hasselt (BE)
(74) Representative: Moens, Marnix Karel Christiane

(57) **Abstract**

The present invention is directed to a method for forming a selective contact for a photovoltaic cell comprising:
a. forming a doped contact layer at the surface of a semiconductor substrate;
b. annealing a portion of the doped contact layer with a laser beam, said portion having a 2D-pattern corresponding to at least a portion of a respective selective contact grid;

characterized in that the laser beam is pulsed and shaped to the 2D-pattern.

In addition, the present invention is also directed to a photovoltaic cell comprising a selective contact formed by that method.

## Description

### FIELD OF THE INVENTION

The present invention relates to a method for forming a selective contact for a photovoltaic cell using laser annealing.

In addition, the present invention is also related to a photovoltaic cell comprising a selective contact formed by such method.

### BACKGROUND OF THE INVENTION

In conventional photovoltaic cell manufacturing, emitter contact formation contains three major steps, namely formation of an emitter layer, which is a relatively highly doped layer at the front of the bulk silicon substrate having a dopant type different from the dopant type of the bulk silicon substrate, formation of an anti-reflective coating (ARC) on top of the emitter layer, and aligned metallization.

As known by a person skilled in the art, photovoltaic cell manufacturers seeking for higher cell performance developed so-called selective emitter technology. A selective emitter contact contains an emitter layer of a given type showing different doping levels and junction depths at specific locations. In such emitter contact only the heavily doped locations will be covered by metal and realize the contacts necessary to perform the photo-generated charges extraction to the external circuit. As a result the efficiency of a photovoltaic cell is improved by 0.5% to 1% compared to a conventional emitter contact with a highly doped emitter layer entirely covering the front side of the photovoltaic cell.

A common technique to achieve an emitter layer showing different doping levels and junction depths at specific locations is laser annealing, since this technique offers significant advantages over a conventional heating process by enabling a very fast and very local heat treatment resulting in a controlled depth of the junction at the heated portion while maintaining a very low overall thermal budget. Therefore in particular, laser annealing is well adapted to process very thin solar cells in the range of 100 micrometer or even lower.

For example WO 2009/128679 describes laser annealing of a selective emitter layer wherein multiple excimer laser beams pass a mask including holes from which then groups of laser beams are simultaneously irradiating portions of the emitter layer corresponding to the finger electrodes and wherein the laser beams are moved in the extension direction of the finger electrodes.

Obviously, a first disadvantage of the above technique is the fact that several laser beams are required for simultaneously irradiating portions of the emitter layer corresponding to the finger electrodes, which is technically complex and not cost effective.

A second disadvantage is that the throughput of such system is quite low since the laser beams scan along the full extension direction of the finger electrodes in a continuous way.

A third disadvantage is that there is limited flexibility regarding shape and size of the portion of the emitter layer to be irradiated. Since the diameter of conventional laser beams is smaller or in the same order as the width of conventional finger electrode lines, that width cannot be increased significantly without (i) increasing the number of laser beams in a group of laser beams passing a hole of the mask, which results in increasingly complex and expensive laser systems, or (ii) repeating the annealing process an number of times along the extension direction of the finger electrodes, resulting in overlapping effects, less throughput and higher photovoltaic manufacturing cost.

Considering the above drawbacks there is a clear need for a method aiming to overcome these drawbacks.

Therefore, as a first object the present invention provides a method for forming a selective contact, which does not require a plurality of laser beams for simultaneously irradiating a plurality of portions of a doped contact layer and which may result in less complex and less expensive laser equipment.

As a second object the present invention provides a method for forming a selective contact which may allow higher throughput and decreased photovoltaic cell manufacturing cost compared to conventional methods.

As a third object the present invention provides a method for forming a selective contact, which may reduce or even minimize overlapping effects.

As a fourth object the present invention provides a method for forming a selective contact enabling a better local control range of junction depth over the whole contact area, which results in increased photovoltaic cell efficiency.

As a fifth object the present invention provides a method for forming a selective contact wherein the annealed doped contact layer may show fewer defects compared to conventional methods, resulting in increased photovoltaic cell efficiency as well.

Further, it is an object of the present invention to provide a method for forming a selective contact wherein the number of overall process steps is decreased compared to conventional methods.

As an additional object, the present invention provides a photovoltaic cell with decreased manufacturing cost and higher efficiency.

The present invention meets the above objects by annealing a portion of the contact layer by means of a pulsed laser beam which is shaped to a 2D-pattern corresponding to at least a portion of a respective selective contact grid.

### SUMMARY OF THE INVENTION

The present invention is directed to a method for forming a selective contact for a photovoltaic cell comprising:
a. forming a doped contact layer at the surface of a semiconductor substrate;
b. annealing a portion of the doped contact layer with a laser beam, said portion having a 2D-pattern corresponding to at least a portion of a respective selective contact grid;
characterized in that the laser beam is pulsed and shaped to the 2D-pattern.

In addition, the present invention is also directed to a photovoltaic cell comprising a selective contact formed by that method.

### DESCRIPTION OF THE INVENTION

According to a first embodiment of the present invention, a method is provided for forming a selective contact for a photovoltaic cell comprising:
a. forming a doped contact layer at the surface of a semiconductor substrate;
b. annealing a portion of the doped contact layer with a laser beam, said portion having a 2D-pattern corresponding to at least a portion of a respective selective contact grid;
characterized in that the laser beam is pulsed and shaped to the 2D-pattern.

By using a laser beam which is pulsed and shaped to the 2D-pattern, wherein the 2D-pattern corresponds to at least a portion of a respective selective contact grid, there is no need anymore to use a plurality of laser beams in order to be able to simultaneously irradiating a plurality of portions of the doped contact layer. Obviously, this may result in less complex and less expensive laser equipment.

Another advantage of the present invention is that, since with one pulse a significant portion of the doped contact layer may be annealed, throughput may increase to industrial manufacturing level and consequently photovoltaic cell manufacturing cost may decrease compared to conventional methods.

Further, by combination of the facts that with one pulse a significant portion of the doped contact layer may be annealed and that the 2D-pattern is not restricted in shape, overlapping effects may be reduced or even minimized.

In the context of the present invention, the doped contact layer is understood as any kind of doped layer at the front or rear side of the bulk photovoltaic cell substrate, having a dopant type different from the dopant type of the bulk substrate (e.g. in case of an emitter contact) or having a dopant concentration which is significantly higher than the dopant concentration in the bulk substrate (e.g. in case of a Back Surface Field (BSF)). In both cases the doped contact layer forms (or behaves like) a junction with the bulk substrate, and serves as a conductive layer between the bulk substrate and the contact electrodes.

In the context of the present invention, the selective contact is understood as any kind of contact in photovoltaic applications of which the doped contact layer shows different doping levels and junction depths at specific locations according to a 2D-pattern, for example a selective emitter contact of front contact cells, a Back Surface Field on Passivated Emitter Rear Locally Diffused Solar Cells (PERL), a selective emitter contact on the rear side of Rear Contact Cells (RCC), of Back Contact Cells (BCC), of Interdigitated Back Contact Cells (IBC) or of Passivated Emitter Rear Contact Cells (PERC).

The 2-D pattern may have any shape corresponding to the lay-out of at least a portion of a respective selective contact grid of any type of photovoltaic cell, such that after annealing the doped contact layer shows different doping levels and junction depths at specific locations.

In particular the 2-D pattern may comprise a plurality of parallel contacts, e.g. finger electrodes of a selective emitter contact grid.

In a further embodiment in accordance with the present invention, a method is provided, wherein the selective contact grid may comprise a plurality of parallel contacts and wherein with each pulse a portion having a 2D-pattern corresponding to at least a portion of the plurality of parallel contacts may be irradiated.

Shaping the laser beam to the 2D-pattern may be achieved by any kind of beam shaping system, such as for example a mask having an aperture corresponding to the 2D-pattern. Such mask may be a solid plate in which an aperture is manufactured. In essence, such aperture is then a hole or an opening through which the laser beam passes and which defines the shape and/or size of the beam spot.

Alternatively, the beam shaping system may comprise a mirror or lens assembly comprising a partially transmitting coating having a higher transmittance area corresponding to the 2D-pattern, surrounded by a lower transmittance area.

In another embodiment, the beam shaping system may comprise an optical system as disclosed in US2009231718 configured to anneal in a single laser pulse a single elongated region, thereby annealing at least a portion of a respective selective contact grid comprising a number of elongated contacts.

Alternatively, the beam shaping system may comprise a diffractive optical element for shaping the beam into multiple parallel lines, thereby annealing in a single laser pulse at least a portion of a respective selective contact grid comprising a number of parallel contacts.

The laser may be any laser whose wavelength, energy and pulse duration is adapted to the process, such as solid state lasers, or excimer laser. Preferably, the laser may be an excimer layer, more preferably a xenon chloride excimer laser.

The wavelength of the laser may be in the range 190 nm to 600 nm, 190 nm to 550 nm, 190 nm to 480 nm due to the high energy absorption of silicon at those wavelengths, and preferably 308 nm.

The laser energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment of the present invention, the laser may be adapted to produce a projected laser beam with an energy density between 0,1 and 10 J/cm², preferably between 1 and 10 J/cm²

In a preferred embodiment, the laser may be an excimer laser adapted to produce a large area output beam of more than 60 cm², more than 80 cm², preferably 100 cm², having a projected beam spot typically of at least 1 cm², at least 5 cm², and up to 10 cm² with an energy density between 0,1 and 10 J/cm².

In a particular embodiment in accordance with the present invention, with each pulse a portion of at least 1 cm², at least 5 cm² , at least 8 cm², or at least 10 cm² may be irradiated, which makes the present invention suitable for industrial manufacturing of photovoltaic cells at high throughputs.

The pulse duration corresponds to an optimum between fast heating for reducing diffusion of dopants and relatively slow cool down for reducing the formation of defects, and may be in the range of 100 ns to 1000 ns, or between 100 ns and 300 ns, or preferably between 100 and 200 nanoseconds.

By using such long pulse, ablation of the doped contact layer may be minimized, while activating doping elements deep enough in the material. Longer pulse durations also enable a better control range of contact junction depth over the whole contact area. Moreover, a long pulse creates fewer defects in the annealed material than shorter pulses and generates less droplets or material loss as encountered with shorter pulses.

In a preferred embodiment of the present invention, the laser may have a wavelength of 308 nm, a pulse duration between 100 and 200 nanoseconds and a projected beam energy density between 0,5 and 10 J/cm².

The semiconductor substrate surface may be of any material suitable for photovoltaic applications such as, but not limited to crystalline silicon, undoped silicon or doped silicon, polycrystalline silicon, implanted silicon, , silicon carbide, amorphous silicon, silicon germanium, III-V compound semiconductors such as gallium arsenide, gallium aluminum arsenide, gallium nitride, II-VI compound semiconductors like cadmium telluride, copper indium diselenide (CulnSe2) or copper indium gallium diselenide (Cu(In,Ga)Se2) and the like, multi-junction semiconductor stacks, and the like.

In an embodiment according to the present invention, a method for forming a selective contact may be provided further comprising forming an anti-reflective coating and/or a passivation dielectric on top of the doped contact layer and annealing the doped contact layer through the anti-reflective coating and/or passivation dielectric.

Such anti-reflective coating or passivation dielectric may be any anti-reflective material or passivation dielectric used in photovoltaic cell manufacturing, such as for example silicon nitride and/or silicon oxide and/or a combination of both.

In accordance with the present invention, a method for forming a selective contact may be provided wherein at least a portion of the anti-reflective coating and/or the passivation dielectric corresponding to the portion of the doped contact layer may be laser ablated. By ablating the anti-reflective coating and/or passivation dielectric from at least the portion corresponding to the respective selective contact grid before forming the metal contact electrodes, the contact resistance between doped contact layer underneath ablated layer and the subsequently deposited metal electrode is decreased resulting in higher cell efficiency.

Further, the contact electrodes may be made thinner because they are at least partially embedded in the anti-reflective coating and/or passivation dielectric. Moreover, since the anti-reflective coating and/or passivation dielectric can be laser ablated in the form of lines with very limited width which can serve as a pattern for self-aligned metal plating, the contact electrodes may be formed with decreased width. Thinner and/or less wide contact electrodes result in less shadow losses and higher short current densities (Jsc) are gained.

Additionally, since contact formation can be done now at lower temperature and contactless, i.e. by self-aligned metal plating, the risk of wafer breakage is reduced in view of the trend to reduce wafer thickness.

In a preferred method in accordance with the present invention, a portion of the anti-reflective coating and/or the passivation dielectric corresponding to at least the portion of the doped contact layer may be laser ablated simultaneously with the laser annealing. By simultaneously annealing the doped contact layer and ablating the anti-reflective coating and/or the passivation dielectric, the number of overall process steps is decreased compared to conventional methods.

As known by a skilled person, conventionally the doped contact layer is formed by high temperature phosphor or boron diffusion, or by other doping process steps followed by high temperature furnace annealing in order to obtain a highly doped contact layer. However, according to the present invention, due to subsequent selective laser annealing, only a lightly doped contact layer is required. Therefore, forming the doped contact layer may be done by treating the front or rear surface of the bulk semiconductor substrate with a doping process step such as for example ion implantation, plasma doping, phosphosilicate glass (PSG) formation obtained from lower temperature diffusion of Phosphorous precursors, borosilicate glass (BSG) formation obtained from lower temperature diffusion of Boron precursors, doped spin-on glass formation and doped dielectric deposition.

Alternatively, another embodiment in accordance with the present invention provides a method for forming a selective contact wherein forming the doped contact layer at the surface of the semiconductor substrate may comprise forming a doped anti-reflective coating and/or doped passivation dielectric on the semiconductor substrate and laser annealing the anti-reflective coating and/or the passivation dielectric. Preferably simultaneously with the laser annealing, a portion of the anti-reflective coating and/or the passivation dielectric may be laser ablated corresponding to the portion of the doped contact layer.

In the latter case, the selective doped contact layer is formed by annealing and simultaneously ablating the anti-reflective coating and/or the passivation dielectric without the need of separated doped contact layer formation as such. This obviously decreases the number of overall process steps to form a selective contact even more compared to conventional methods.

A method according to the invention may further comprise aligning the projected laser beam in XYZ-direction with the portion to be irradiated.

A method in accordance with the present invention may further comprise focusing the image of the 2D-pattern on the region to be irradiated by means of an objective lens.

A method in accordance with the present invention may further comprise matching the size of the image of the 2D-pattern to the size of the portion to be irradiated. This may be obtained by means of a variable image magnification system.

Further adjustment may be performed by visualizing the beam spot on the semiconductor material layer using a camera, measuring its size and adjusting the magnification.

A method of the present invention may comprise also pattern recognition. This may be achieved by a pattern recognition system comprising a camera, mechanically linked to a stage for holding the semiconductor material, and positioned above the material layer surface. In a specific embodiment, the image from the camera may be processed to locate several (typically 3) alignment marks that have been etched or laser ablated on the semiconductor material. The alignment marks provide the precise location of the semiconductor material in the coordinate system of the laser equipment.

In addition, the present invention provides a photovoltaic cell comprising a selective contact formed by a method in accordance with any of the above claims. Such photovoltaic cells may be for example standard mono-crystalline and multi-crystalline solar cells, N-type and P-type solar cells, epitaxial silicon solar cells grown on different types of substrates, hetero-junction solar cells, Passivated Emitter Rear Locally Diffused Solar Cells (PERL), Passivated Emitter Rear Contact Cells (PERC), Back Contact or Rear Contact Solar Cells (RCC, BCC) and Interdigitated Back Contact Cells (IBC).

### EXAMPLE 1

Conventional emitter contact forming process:
1) POCl3 furnace diffusion at high temperature on p-type bulk silicon for formation of heavily doped n-type emitter layer
2) Phosphosilicate glass etch
3) deposition of SiNx ARC/passivation layer
4) Aligned front side metallization by screen printing

Prior art selective emitter forming process as described in for example WO 20091128679:
1) POCl3 furnace diffusion at lower temperature on p-type bulk silicon for formation of lightly doped n-type emitter layer
2) selective laser annealing of emitter layer
3) Phosphosilicate glass etch
4) deposition of SiNx ARC/passivation layer
5) Aligned front side metallization by screen printing

Selective emitter forming process in accordance with the present invention:
1) POCl3 furnace diffusion at lower temperature on p-type bulk silicon for formation of lightly doped n-type emitter layer
2) selective laser annealing by pulsed laser beam shaped to the 2D-pattern of the selective emitter contact grid;
3) Phosphosilicate glass etch
4) deposition of SiNx ARC/passivation layer
5) aligned front side metallization by screen printing

Alternative selective emitter forming process in accordance with the present invention:
1) POCl3 furnace diffusion at lower temperature on p-type bulk silicon for formation of lightly doped n-type emitter layer
2) selective laser annealing by pulsed laser beam shaped to the 2D-pattern of the selective emitter contact grid;
3) Phosphosilicate glass etch
4) deposition of SiNx ARC/passivation layer
5) laser ablation by pulsed laser beam shaped to the 2D-pattern of the selective emitter contact grid;
6) front side metallization by self-aligned metal plating

Another alternative selective emitter forming process in accordance with the present invention:
1) POCl3 furnace diffusion at lower temperature on p-type bulk silicon for formation of lightly doped n-type emitter layer
2) Phosphosilicate glass etch
3) deposition of SiNx ARC/passivation layer
4) selective laser annealing and laser ablation by pulsed laser beam shaped to the 2D-pattern of the selective emitter contact grid;
5) front side metallization by self-aligned metal plating

Another alternative selective emitter forming process in accordance with the present invention:
1) deposition of doped SiNx ARC/passivation layer
2) selective laser annealing and laser ablation by pulsed laser beam shaped to the 2D-pattern of the selective emitter contact grid;
3) front side metallization by self-aligned metal plating

### EXAMPLE 2

Below a conventional Interdigitated Back Contact (IBC) Solar Cell manufacturing process flow is described using 6 steps of photolithography and a final sinter and annealing step (as described in Practical Handbook of Photovoltaics, Fundamentals and Applications, Tom Markvart & Luis Castaner, Elsevier):
1) Initial oxidation of a high lifetime <100> FZ Silicon wafer
2) N+ emitter photolithography
3) Oxide etch opening N+ emitter regions
4) Phosphorous pre-deposition
5) P+ emitter photolithography
6) Oxide etch opening P+ emitter regions
7) Boron pre-deposition
8) Texture backside of wafer (solar cell front side)
9) Grow thin oxide or dielectric
10) Contact photolithography
11) Oxide or dielectric etch opening contact regions
12) Level 1 metallisation
13) Metal 1 photolithography
14) Metal 1 etch
15) Deposit intermetal dielectric
16) Via photolithography
17) Intermetal dielectric etch
18) Level 2 metallisation
19) Metal 2 Photolithography
20) Metal 2 etch
21) Deposition Anti-reflective Coating
22) Sinter and Anneal
23) Dicing and Testing

In an Interdigitated Back Contact (IBC) Solar Cell manufacturing process flow in accordance with the present invention, the selective laser annealing by pulsed laser beam shaped to a 2D-pattern may be used to form either N+ emitter regions or P+ emitter regions or both instead of using photolithography.

## Claims

1. A method for forming a selective contact for a photovoltaic cell comprising:
a. forming a doped contact layer at the surface of a semiconductor substrate;
b. annealing a portion of the doped contact layer with a laser beam, said portion having a 2D-pattern corresponding to at least a portion of a respective selective contact grid;
**characterized in that** the laser beam is pulsed and shaped to the 2D-pattern.

2. A method according to claim 1, wherein the selective contact grid comprises a plurality of parallel contacts and wherein with each pulse a portion having a 2D-pattern corresponding to at least a portion of the plurality of parallel contacts is irradiated.

3. A method according to claims 1 or 2, wherein with each pulse a portion of at least 1 cm² is irradiated.

4. A method according to claims 1 to 3, wherein the laser annealing is performed with a projected beam energy density between 0,1 and 10 J/cm².

5. A method according to claims 1 to 4, wherein the pulsed laser beam has a pulse duration between 100 and 200 nanoseconds.

6. A method according to claims 1 to 5, wherein annealing is performed by an excimer laser.

7. A method according to claims 1 to 6, comprising forming an anti-reflective coating and/or a passivation dielectric on top of the doped contact layer and laser ablating at least a portion of the anti-reflective coating and/or passivation dielectric corresponding to the portion of the doped contact layer,

8. A method according to claims 1 to 6, comprising forming an anti-reflective coating and/or a passivation dielectric on top of the doped contact layer and performing the laser annealing through the anti-reflective coating and/or the passivation dielectric.

9. A method according to claim 8, wherein simultaneously with the laser annealing, a portion of the anti-reflective coating and/or the passivation dielectric is laser ablated corresponding to the portion of the doped contact layer.

10. A method according to claims 1 to 6, wherein forming the doped contact layer at the surface of the semiconductor substrate comprises forming a doped anti-reflective coating and/or a doped passivation dielectric on the semiconductor substrate and laser annealing the anti-reflective coating and/or the doped passivation dielectric.

11. A method according to claim 10, wherein simultaneously with the laser annealing, a portion of the anti-reflective coating and/or the passivation dielectric is laser ablated corresponding to the portion of the doped contact layer.

12. A method according to any of the above claims, wherein the doped contact layer is an emitter layer and wherein the selective contact layer is a selective emitter contact.

13. A photovoltaic cell comprising a selective contact formed by a method in accordance with any of the above claims.
